# FASCICULE DE BREVET EUROPEEN

(11) **EP 0 865 639 B1**
(45) Date de publication et mention de la délivrance du brevet: **25.07.2001**
(21) Numéro de dépôt: 96941065.3
(22) Date de dépôt: 25.11.1996
(51) Int. Cl.: G06K 19/077, H05K 5/02, G06F 1/18

(54) **BOITIER POUR CARTE AMOVIBLE ENFICHABLE AU FORMAT ETENDU**
GEHÄUSE FÜR EINE LÄSBARE EINSTECKKARTE MIT ERWEITERTEM FORMAT
HOUSING FOR AN EXTENDED-FORMAT RELEASABLE PLUG-IN CARD

(30) Priorité: 23.11.1995 FR 9513965
(43) Date de publication de la demande: 23.09.1998
(73) Titulaire: GEMPLUS, 13881 Gémenos Cédex (FR)
(72) Inventeur: AGOYAN, Michel, F-13012 Marseille (FR); CHOMETTE, Michel, F-13122 Ventabren (FR)
(86) Numéro de dépôt international: FR9601859
(87) Numéro de publication internationale: WO9719422

(56) Documents cités:
- EP-A- 0 602 778
- EP-A- 0 661 617

## Description

L'invention concerne un boîtier pour carte amovible enfichable, au format étendu, destinée à être en partie insérée, de façon temporaire, dans un micro-ordinateur (ou ordinateur personnel, ou PC de l'anglais "Personal Computer").

Les cartes amovibles enfichables sont généralement connues sous l'appellation cartes PCMCIA et sont réalisées, sur des cartes à circuit imprimé, selon la norme PCMCIA définie par l'association du même nom ("Personal Computer Memory Card International Association" 1030 B East Duane Avenue Sunnyvale, California). Elles comportent plusieurs puces à circuit intégré et un connecteur femelle de 68 broches enfichable dans un connecteur mâle correspondant du micro-ordinateur. Ces cartes sont principalement des cartes à mémoire de masse qui pourraient à l'avenir remplacer les disquettes et autres moyens de stockage de masse de type magnétique. Elles ont des capacités de stockage équivalentes et sont beaucoup plus rapides d'accès que les mémoires magnétiques. Elles peuvent servir aussi d'extension de mémoire vive du micro-ordinateur.

Typiquement, les dimensions standards des boîtiers, permettant de protéger ces cartes PCMCIA contre tous les chocs mécaniques et les agressions extérieures éventuelles, sont d'environ 5,4 centimètres par 8,5 centimètres et leur épaisseur d'environ 3 à 5 millimètres.

La norme PCMCIA prévoit des extensions de mémoire afin d'augmenter les capacités de stockage de ces cartes. Cela pose de nombreux problème de réalisation pratique. En effet, il faut prévoir un nouveau boîtier pour y loger la carte munie de son extension tout en respectant certaines recommandations soumises par l'association PCMCIA et relatives aux dimensions. La partie standard, de la carte PCMCIA au format étendu, est toujours destinée à être insérée dans la fente d'un micro-ordinateur, alors que la partie étendue, qui est reliée à la partie standard, est vouée à rester à l'extérieur du micro-ordinateur.

L'association PCMCIA a donné quelques recommandations quant aux dimensions du boîtier apte à renfermer la partie étendue. Les recommandations n'ont rien de définitif et peuvent encore évoluer. C'est pourquoi, il n'existe pas actuellement de boîtier commercialisé pour les dimensions recherchées.

Une solution a cependant été envisagée, notamment dans le document EP.A.O.602778. Cette solution consiste à réaliser deux boîtiers indépendants et à les connecter. Le premier boîtier, existant, renferme la partie standard d'une carte PCMCIA. Le deuxième boîtier, que l'on réalise aux dimensions de l'extension, renferme cette-dernière. Il faut alors rajouter un connecteur mâle (ou femelle) au boîtier existant, et le connecteur complémentaire au deuxième boîtier. Ces deux connecteurs supplémentaires permettent ainsi d'assurer à la fois une liaison électrique et une liaison mécanique entre la partie standard de la carte et son extension.

Cependant on voit tout de suite que cette solution entraîne de nombreux inconvénients. En effet, la réalisation d'un deuxième connecteur enfichable sur une carte PCMCIA au format standard occasionne une perte d'environ 20 mm de surface sur 85 mm de surface totale, soit une perte d'environ 25 % de surface disponible. Cette perte de surface disponible est considérable dans la mesure où le problème à résoudre consiste à étendre la zone mémoire, c'est-à-dire à maximiser la surface disponible sur une ou plusieurs cartes à circuit imprimé.

De plus le fait d'enficher deux boîtiers l'un dans l'autre, pour relier la partie standard d'une carte PCMCIA à son extension, ne permet pas d'obtenir une liaison mécanique fiable. En effet, étant donné que l'extension se trouve à l'extérieur du micro-ordinateur, un simple choc sur son boîtier peut entraîner une détérioration, voire même une rupture, de la liaison entre les deux connecteurs supplémentaires, c'est-à-dire une détérioration des liaisons électrique et mécanique créées entre la partie standard et l'extension. Par conséquent, deux boîtiers indépendants raccordés l'un à l'autre, en vue de réaliser une carte amovible enfichable au format étendu, forment un dispositif fragile, dont la résistance aux chocs mécaniques est très faible. Enfin, le coût de fabrication de ces boîtiers est trop élevé pour qu'ils puissent être distribués à grande échelle.

Aucune solution satisfaisante n'a encore été proposée jusqu'à présent pour fabriquer un boîtier pour carte amovible au format étendu.

La présente invention permet de pallier tous les inconvénients précités puisqu'elle propose un boîtier comportant deux blocs solidaires l'un de l'autre de manière à ce qu'ils n'en forment plus qu'un. Ces deux blocs assurent une liaison mécanique robuste entre la partie standard d'une carte PCMCIA et son extension.

L'invention se rapporte plus particulièrement à un boîtier pour carte amovible enfichable au format étendu, le boîtier comportant un premier bloc, réalisé au format standard des cartes enfichables et destiné à contenir la partie standard de la carte insérée dans la fente d'un micro-ordinateur, et un deuxième bloc. Ce boîtier est caractérisé en ce que le deuxième bloc est apte à recevoir au moins l'extension de la carte et comprend des attelles destinées à être placées entre les bords latéraux de la carte et ceux du premier bloc, de manière à solidariser lesdits premier et deuxième blocs, la carte supportant à la fois la partie standard et l'extension.

Le boîtier selon l'invention est réalisé de telle manière qu'il se présente, une fois assemblé, sous la forme d'un seul bloc. Il est destiné à renfermer une seule carte à circuit imprimé qui supporte à la fois la partie standard et l'extension. Grâce à ce boîtier, la surface de circuit imprimé disponible est maximisée puisqu'il n'y a pas d'élément supplémentaire de fixation, tel qu'un connecteur enfichable, susceptible d'entraîner une perte de surface. Les attelles assurent une bonne rigidité mécanique de l'ensemble du boîtier. Le coût de fabrication est en outre notablement réduit, puisqu'il n'y a plus de nécessité de rajouter d'éléments supplémentaires de fixation.

D'autres particularités et avantages de l'invention apparaîtront à la lecture de la description faite à titre d'exemple illustratif et non limitatif en référence aux figures annexées qui représentent :
- la figure 1, une vue générale en perspective d'un boîtier pour carte enfichable au format étendu,
- la figure 2, un schéma d'un mode de réalisation d'un boîtier selon l'invention,
- la figure 3, une vue éclatée d'un élément d'un boîtier selon l'invention,
- la figure 4, une vue de dessus d'un boîtier selon l'invention en partie introduit dans la fente d'un micro-ordinateur.

Le boîtier, pour carte amovible à connecteur enfichable au format étendu, selon l'invention est désigné par la référence générale 10. Ce boîtier comporte deux blocs: un premier bloc 12 est réalisé au format standard des cartes enfichables et est destiné à contenir la partie standard d'une carte PCMCIA, laquelle est insérée dans la fente 31 d'un micro-ordinateur 30; un deuxième bloc 16 est prévu pour contenir une extension de mémoire de la carte PCMCIA. La partie étendue de la carte est destinée à rester à l'extérieur de la fente 31 du micro-ordinateur. En principe, la partie standard contenue dans le premier bloc 12 comporte un connecteur externe femelle 11 de 68 broches qui peut pénétrer au fond de la fente 31, laquelle est équipée d'un connecteur mâle correspondant de 68 broches. Ce connecteur mâle constitue un port d'entrée-sortie parallèle pour le micro-ordinateur et la communication entre la carte amovible enfichable et le micro-ordinateur est une communication de type parallèle.

La carte PCMCIA comporte une ou plusieurs puces de circuit intégré et des connexions sont réalisées entre ces puces ou entre ces puces et les différentes broches du connecteur externe 11 enfichable. Mais la carte peut avoir d'autres fonctions et comprendre par exemple un microprocesseur etc.

Typiquement, les dimensions du premier bloc 12 standard, selon la norme PCMCIA, sont d'environ 5,4 centimètres par 8,5 centimètres et d'une épaisseur d'environ 3 à 5 millimètres.

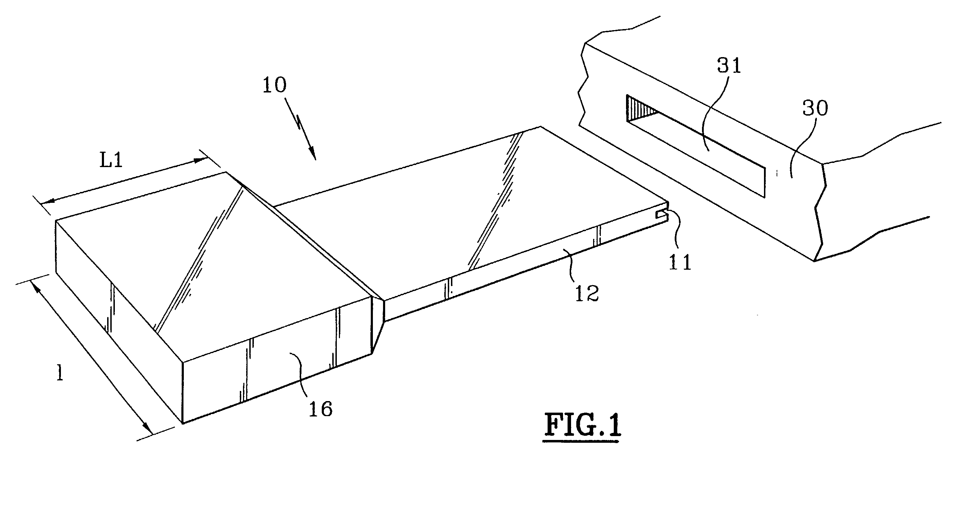

Le boîtier 10 renfermant la carte amovible enfichable est représenté hors de la fente 31 du micro-ordinateur 30. Le bloc 12 est inséré dans la fente 31 dans le sens de la flèche telle que représentée sur la figure 1.

En ce qui concerne les dimensions du bloc 16 prévu pour l'extension de la carte, l'association PCMCIA a émis quelques recommandations, mais rien n'a été clairement décidé à ce jour. Le boîtier selon l'invention a par conséquent été réalisé dans des dimensions adaptables à de futures normes qui entreraient dans le cadre de ces recommandations.

La longueur L₁ du bloc 16 est définie comme étant parallèle aux côtés longitudinaux du bloc standard 12, et sa largeur 1 est définie comme étant parallèle aux petits côtés du bloc standard 12.

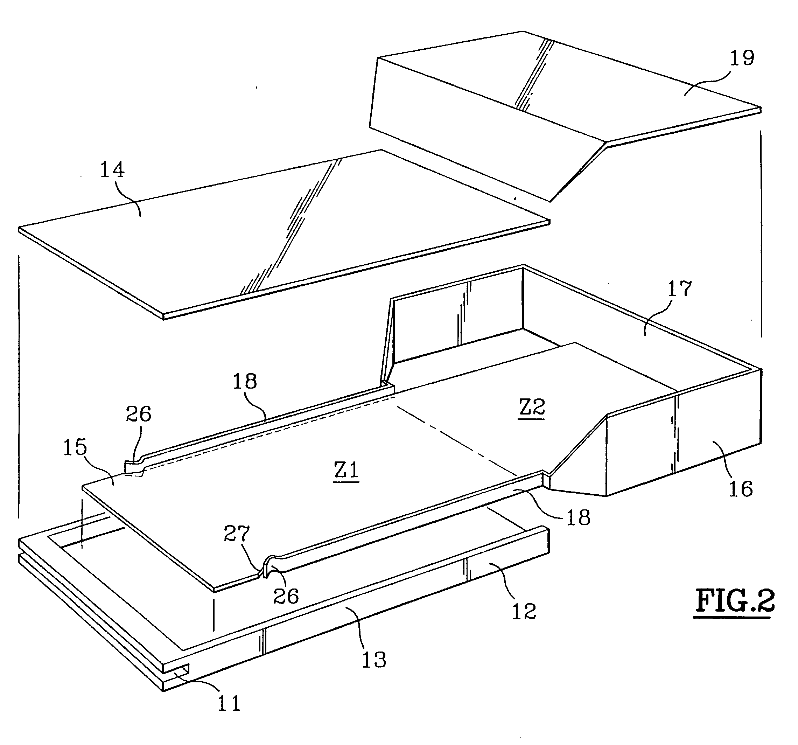

Des détails du boîtier de la figure 1 seront mieux compris au regard de la figure 2 . Sur cette figure en effet, le boîtier est représenté sous forme éclatée.

De manière avantageuse, la partie standard et la partie étendue, de la carte PCMCIA, sont réalisées sur une même carte à circuit imprimé 15. Cette carte comporte deux zones: la première zone Z₁ correspond à la partie standard de la carte et la deuxième zone Z₂ correspond à la partie étendue. La première zone Z₁ de la carte à circuit imprimé 15 est par conséquent destinée à être placée dans le premier bloc 12 du boîtier, tandis que l'autre zone Z₂ est destinée à être placée dans le deuxième bloc 16.

Le premier bloc 12 est constitué d'une surface arrière 13 et d'une surface avant 14 dont l'assemblage est de préférence effectué au moyen de clips. Ces clips sont par exemple des ergots, pratiqués sur la face inférieure de la surface avant 14 qui viennent s'enclencher dans des évidements pratiqués sur la face supérieure de la surface arrière 13. Ces clips ne sont pas visibles sur la figure 2. Ils sont par exemple au nombre de quatre : deux de chaque côté, le long des bords longitudinaux du bloc 12 ; mais ils peuvent être plus ou moins nombreux. Lorsque les surfaces arrière 13 et avant 14 sont assemblées, la largeur maximale de la carte à circuit imprimé 15, à l'intérieur du bloc 12, est environ égale à 53,5 mm.

De manière avantageuse, des attelles 18 sont prévues dans le prolongement du deuxième bloc 16. Ces attelles 18 sont destinées à être placées entre les bords latéraux de la carte 15 et ceux du premier bloc 12. Elles permettent ainsi de solidariser les deux blocs 12 et 16, de manière à les rendre indissociables et à ce que le boîtier, pris dans son ensemble, ne forme plus qu'un seul bloc. En outre, les attelles 18 assurent une bonne rigidité mécanique à l'ensemble du boîtier.

De préférence, chaque attelle 18 comporte, à son extrémité par exemple, un ergot 26 apte à s'enclencher dans un évidement 27 pratiqué sur la carte à circuit imprimé 15. Les ergots 26 permettent ainsi de bloquer le deuxième bloc 16 dans le bloc standard 12, et d'éviter tout mouvement de recul éventuel du deuxième bloc 16 par rapport à la carte à circuit imprimé 15. Dans une variante de réalisation il est tout-à-fait possible de pratiquer ces ergots à un autre endroit sur les attelles, au milieu par exemple.

Le châssis 17 du deuxième bloc 16 est par exemple réalisé dans une tôle d'acier inoxydable. Cette tôle a l'avantage d'être souple et facile à travailler, si bien qu'il est aisé de la mettre en forme. Du fait de cette souplesse, les attelles 18 ont tendance à s'écarter ou à se rapprocher l'une de l'autre lorsqu'elles ne sont pas tenues. Dans le boîtier selon l'invention, la tenue latérale des attelles est par conséquent assurée d'une part grâce à la carte 15 et d'autre part grâce aux bords latéraux du bloc standard 12.

La surface avant 19 du deuxième bloc 16 est de préférence réalisée dans une matière plastique.

Sur la figure 2, le deuxième bloc 16 est plus large que le bloc standard 12. Cette largeur n'est pas figée, elle peut varier d'un boîtier à un autre.

Les deux blocs 12 et 16 permettant de réaliser le boîtier pour carte PCMCIA au format étendu selon la présente invention, sont assemblés sans élément supplémentaire de fixation, selon un ordre précis. Une fois assemblés, ces blocs ne peuvent être facilement dissociés. L'assemblage des blocs du boîtier consiste tout d'abord à séparer la surface arrière 13 de la surface avant 14 du bloc standard 12. Dans un deuxième temps, les attelles 18 du deuxième bloc 16 sont placées le long des bords longitudinaux de la carte 15 à circuit imprimé de manière à ce que les ergots 26 soient enclenchés dans les évidements 27. Puis l'ensemble constitué par le bloc 16 fixé, au moyen des attelles 18, sur la carte 15 est engagé dans le bloc standard 12. La dernière étape de l'assemblage consiste à fixer la surface avant 14 du bloc standard 12 sur la surface arrière 13, et la surface avant 19 du deuxième bloc 16, réservé à l'extension, sur le châssis 17.

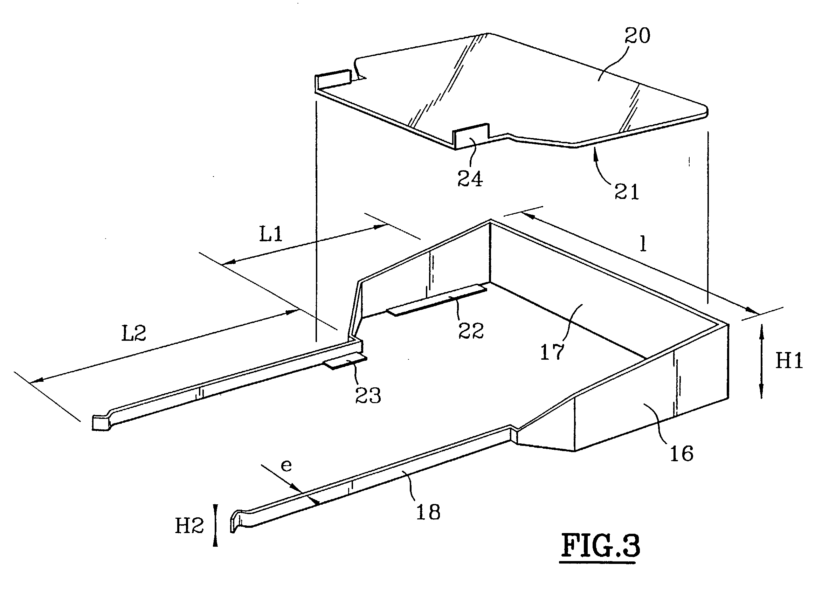

La figure 3 représente une vue éclatée du deuxième bloc 16 du boîtier selon l'invention, c'est-à-dire une vue du bloc réservé pour contenir la deuxième zone Z2 de la carte 15 formant l'extension de la carte PCMCIA. Le châssis 17 de ce bloc 16 a de préférence une forme cubique tel que représenté sur la figure 2. Cependant, selon une variante, il peut se présenter sous une autre forme. Ainsi, sur la figure 3, les bords longitudinaux du bloc n'ont pas la même hauteur à chacune de leurs extrémités si bien qu'ils se présentent sous la forme de quadrilatères quelconques.

En outre, il est avantageux de réaliser un tel bloc 16 de manière à ce qu'il présente une hauteur suffisamment élevée pour qu'il puisse renfermer une ou plusieurs autres cartes à circuit imprimé. Ainsi, la (les) carte(s) supplémentaires(s) est (sont) empilée(s) (les) l'une(s) sur (les) l'autre(s) et est (sont) connectée(s) (entre-elles et) avec la carte 15 au format étendu. La connexion entre les cartes se fait au moyen de fils conducteurs par exemple. Cet empilement de cartes permet ainsi d'augmenter encore notablement la surface disponible de circuit imprimé, c'est-à-dire la zone mémoire et la capacité de stockage.

Le fond 20 du bloc 16 est assemblé au châssis 17 par soudage par exemple. Il est placé de telle sorte que sa face inférieure 21 vienne en appui contre des languettes 22 et 23 pratiquées dans la partie inférieure du châssis 17. Le fond 20 est ensuite soudé, ou collé par exemple, aux languettes 22 et 23.

De préférence, d'autres petites languettes 24 sont prévues sur le fond 20, de chaque côté de son extrémité avant destinée à venir se loger entre les deux attelles 18 du bloc 16. Ces languettes 24 sont également soudées, ou collées, sur les attelles 18. Elles apportent un renfort supplémentaire, et contribuent au maintient latéral des attelles 18 et à l'obtention d'une bonne rigidité mécanique de l'ensemble du boîtier selon l'invention. La surface avant du bloc 16 n'est pas représentée sur la figure 3, mais comme il a été décrit précédemmment elle est de préférence réalisée en matière plastique.

Les dimensions du bloc 16 prévu pour recevoir la zone Z₂ de la carte PCMCIA 15, c'est-à-dire la zone d'extension mémoire, sont données ici à titre indicatif. On ne saurait en aucun cas se limiter à ces dimensions. Elles sont en effet tout-à-fait adaptables à de futures normes susceptibles d'être définies par l'association PCMCIA.

Le deuxième bloc 16 peut ainsi présenter une hauteur H₁ comprise entre 10 et 25 mm, une largeur 1 comprise entre 54 et 70 mm et une longueur L₁ comprise entre 40 et 50 mm.

Les attelles 18 possèdent de préférence une longueur L₂ comprise entre 50 et 60 mm de manière à bien s'avancer dans le bloc standard 12, une hauteur H₂ comprise entre 2 et 3 mm et une épaisseur e comprise entre 0,1 et 0,7 mm. Les attelles 18 sont distantes l'une de l'autre d'une valeur comprise entre 53,7 et 52,5 mm.

Grâce au boîtier selon l'invention, la surface disponible sur la carte à circuit imprimé 15 est maximisée. En effet, la largeur de la carte n'est diminuée que de la valeur de l'épaisseur des attelles et la longueur totale ( L₁ + L₂ ) est totalement disponible puisqu'il n'y a pas d'élément(s) supplémentaire(s), tel(s) que des connecteurs enfichables, susceptibles d'entraîner une perte de surface. De plus le deuxième bloc 16 du boîtier étant fabriqué dans une tôle peu chère d'acier inoxydable, qui se plie facilement pour créer des formes variées, et le bloc standard 12 n'étant pas modifié, le coût de fabrication du boîtier selon l'invention est relativement bas et adapté pour une distribution à grande échelle. Enfin, le boîtier offre une bonne rigidité mécanique, puisque les deux blocs sont assemblés de telle manière qu'ils deviennent indissociables.

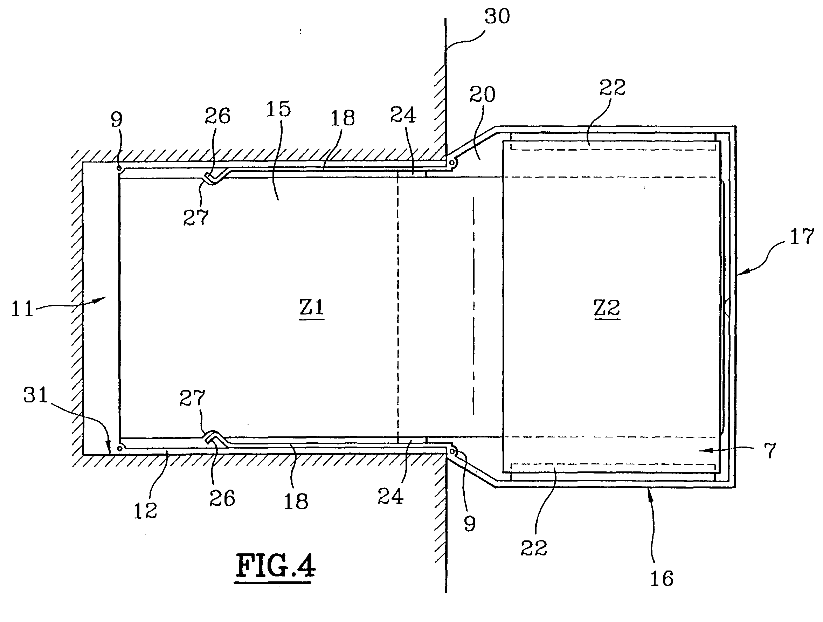

La figure 4 représente une vue de dessus d'un boîtier conforme à l'invention et en partie introduit dans la fente 31 d'un micro-ordinateur 30. Les surfaces avant 14 et 19 des blocs 12 et 16 ne sont pas représentées sur cette figure. De plus, les parties communes aux figures précédentes sont désignées par les mêmes références et ne sont pas décrites.

Les clips permettant de refermer le boîtier sont représentés par de petits cercles et sont désignés par la référence 9. Les languettes 24 appartenant au fond 20, du bloc 16 réservé à la partie étendue, sont de préférence soudées ou collées aux attelles 18. Elles permettent ainsi de contribuer au maintien latéral des attelles et à l'obtention d'une bonne rigidité mécanique de l'ensemble du boîtier.

Une variante consistant à empiler une carte supplémentaire 7 à circuit imprimé sur la carte 15, est représentée sur la figure 4. La carte supplémentaire 7 est connectée à la carte 15 au moyen de fils conducteurs par exemple, traversant des trous pratiqués sur la carte supplémentaire 7 et non repésentés sur la figure 4.

## Revendications

1. Boîtier pour carte amovible enfichable (15) au format étendu, le boîtier comportant un premier bloc (12), réalisé au format standard des cartes enfichables et destiné à contenir la partie standard (Z1) de la carte (15) insérée dans la fente (31) d'un micro-ordinateur (30), et un deuxième bloc (16), caractérisé en ce que le deuxième bloc (16) est apte à recevoir au moins l'extension (Z2) de la carte (15), et comprend des attelles (18) destinées à être placées entre les bords latéraux de la carte (15) et ceux du premier bloc (12), de manière à solidariser lesdits premier et deuxième blocs (12 et 16), la carte (15) supportant à la fois la partie standard (Z1) et l'extension (Z2).

2. Boîtier selon la revendication 1, caractérisé en ce que chaque attelle (18) comporte un ergot (26) apte à s'enclencher dans un évidement (27) correspondant pratiqué sur la carte (15).

3. Boîtier selon l'une des revendications 1 à 2, caractérisé en ce que le deuxième bloc (16) est réalisé dans une tôle d'acier inoxydable.

4. Boîtier selon l'une des revendications 1 à 3, caractérisé en ce que le deuxième bloc (16) est apte à recevoir une ou plusieurs autres cartes à circuit imprimé, empilées les unes sur les autres et connectées entre elles.

5. Boîtier selon l'une des revendications 1 à 4, caractérisé en ce que le deuxième bloc (16) possède une hauteur (H₁) comprise entre 10 et 25 mm, une largeur (1) comprise entre 54 et 70 mm, et une longueur (L₁) comprise entre 40 et 50 mm.

6. Boîtier selon l'une des revendications 1 à 5, caractérisé en ce que les attelles (18) possèdent une longueur (L₂) comprise entre 50 et 60 mm, une hauteur (H₂) comprise entre 2 et 3 mm et une épaisseur (e) comprise entre 0,1 et 0,7 mm et en ce qu'elles sont distantes l'une de l'autre d'une valeur comprise entre 53,7 et 52,5 mm.

## Patentansprüche

1. Gehäuse für eine herausziehbare Steckkarte (15) mit verlängertem Format, wobei das Gehäuse einen ersten Block (12) im Standardformat von Steckkarten zur Aufnahme des Standard-Teilstücks (Z1) der Karte (15), das in den Schlitz (31) eines Mikro-Computers (30) gesteckt wird, sowie einen zweiten Block (16) umfasst, dadurch gekennzeichnet, dass sich der zweite Block (16) zur Aufnahme mindestens der Verlängerung (Z2) der Karte (15) eignet und Schienen (18) enthält, die zwischen den seitlichen Rändern der Karte (15) und denen des ersten Blocks (12) angeordnet werden, wobei die genannten ersten und zweiten Blöcke (12) und (16) auf einander abgestimmt sind, und wobei die Karte (15) sowohl das Standard-Teilstück (Z1) als auch das Verlängerungsstück (Z2) aufweist.

2. Gehäuse gemäß Anspruch 1, dadurch gekennzeichnet, dass jede Schiene (18) einen Vorsprung (26) aufweist, um in eine entsprechende Aussparung (27), die auf der Karte (15) gebildet ist, einzuhaken.

3. Gehäuse gemäß Anspruch 1 oder 2, dadurch gekennzeichnet, dass der zweite Block (16) aus einem unoxidierbaren Stahlblech hergestellt ist.

4. Gehäuse gemäß einem der Ansprüche 1 bis 3, dadurch gekennzeichnet, dass sich der zweite Block (16) zur Aufnahme einer oder mehrerer weiterer Karten mit gedrucktem Schaltkreis eignet, die aufeinander gestapelt und miteinander verbunden sind.

5. Gehäuse gemäß einem der Ansprüche 1 bis 4, dadurch gekennzeichnet, dass der zweite Block (16) eine Höhe (H1) von 10 bis 25 mm, eine Breite (1) von 54 bis 70 mm und eine Länge (L1) von 40 bis 50 mm aufweist.

6. Gehäuse gemäß einem der Ansprüche 1 bis 5, dadurch gekennzeichnet, dass die Schienen (18) eine Länge (L2) von 50 bis 60 mm, eine Höhe (H2) von 2 bis 3 mm und eine Dicke (e) von 0,1 bis 0,7 mm aufweisen und 53,7 bis 52,5 mm von einander beabstandet sind.

## Claims

1. A case for an extended-format removable plug-in card (15), the case having a first unit (12), produced to the standard format of plug-in cards and intended to contain the standard part (Z1) of the card (15) inserted in the slot (31) of a microcomputer (30), and a second unit (16) characterised in that the second unit (16) is able to receive at least the extension (Z2) of the card (15), and comprises supports (18) intended to be placed between the lateral edges of the card (15) and those of the first unit (12), so as to join together the said first and second units (12 and 16), the card (15) supporting both the standard part (Z1) and the extension (Z2).

2. A case according to Claim 1, characterised in that each support (18) has a lug (26) able to engage in a corresponding recess (27) formed on the card (15).

3. A case according to one of Claims 1 to 2, characterised in that the second unit (16) is produced from a sheet of stainless steel.

4. A case according to one of Claims 1 to 3, characterised in that the second unit (16) is able to receive one or more other printed circuit cards, stacked one on top of the other and connected to each other.

5. A case according to one of Claims 1 to 4, characterised in that the second unit (16) has a height (H₁) of between 10 and 25 mm, a width (1) of between 54 and 70 mm and a length (L₁) of between 40 and 50 mm.

6. A case according to one of Claims 1 to 5, characterised in that the supports (18) have a length (L₂) of between 50 and 60 mm, a height (H₂) of between 2 and 3 mm and a thickness (e) of between 0.1 and 0.7 mm, and in that they are distant from each other by between 53.7 and 52.5 mm.
